# EUROPEAN PATENT SPECIFICATION

(11) **EP 0 395 443 B1**
(45) Date of publication and mention of the grant of the patent: **17.02.1993**
(21) Application number: 90304643.1
(22) Date of filing: 27.04.1990
(51) Int. Cl.: H05K 3/38, H05K 3/20, H05K 3/00, B32B 15/08

(54) **Circuit board and overlay**
Leiterplatte und Überzug
Plaque à circuit imprimé et revêtement

(30) Priority: 28.04.1989 JP 109491/89
(43) Date of publication of application: 31.10.1990
(73) Proprietor: NIKKAN INDUSTRIES CO., LTD., Tokyo (JP)
(72) Inventor: Taniguchi, Sakan, Itabashi-ku, Tokyo 174 (JP)
(74) Representative: Darby, David Thomas

(56) References cited:
- EP-A- 0 160 439
- EP-A- 0 284 939
- US-A- 4 752 499

## Description

This invention relates to a polyimide film, and more particularly it relates to a flexible printed circuit board and a coverlay film comprising a polyimide film as the insulator thereof and to manufacturing methods therefor.

It has been proposed, e.g. in US-A-4 752 499, to manufacture a flexible printed circuit board by using as an insulator, for instance, a polyimide film and attaching the same to a metal foil with an adhesive. The adhesives used for the purpose may be epoxy/nylon base adhesives or adhesives of epoxy resin/acrylonitrile butadiene rubber containing carboxyl groups.

Flexible printed circuit boards have recently become widely used in telecommunications, and in consumer and industrial appliances. As the packaging of those appliances becomes increasingly simpler, more compact, more reliable, and highly functional, the restrictions imposed on flexible printed circuit boards become extremely severe. The boards are required to have high thermal resistance, good weatherability, and to meet severe conditions entirely different from those for glass epoxy board, ANSI grade, G-10 or FR-4.

More specifically, they are required to have good thermal resistance and electrical insulation properties as well as flexibility, but these requirements are completely contradictory. If emphasis is placed on flexibility, thermal resistance and electric insulation properties are sacrificed to some extent.

In practice, the aforementioned epoxy/nylon adhesives provide high bonding strength but the boards are inferior in electrical insulation properties at a high humidity. Boards using adhesives of epoxy resin/acrylonitrile butadiene rubber containing carboxyl groups are superior in bonding strength but inferior in thermal resistance, being known to deteriorate drastically in bonding strength and flexibility when heated.

The same applies to a coverlay film which is used to protect circuits during processing of flexible printed circuit boards.

The prior art flexible printed circuit boards and coverlay films in short cannot adequately meet various conditions currently required of them.

There remains a need to obviate the aforementioned problems and to provide a flexible printed circuit board and a coverlay film that are excellent in bonding strength, thermal resistance, chemical resistance, electrical insulation properties, and flexibility, as well as excellent in moisture resistance and weatherability.

The present applicants conducted research in order to solve the problems mentioned above, and now provide a method of manufacturing flexible printed circuit boards and the resulting products and corresponding intermediates using release paper.

In one embodiment, the present invention provides a polyimide film having on at least one primary surface a dual layer adhesive comprising a first thermosetting adhesive A in the form of a layer of thickness at most 5 µm and a second thermosetting adhesive B, different from adhesive A, on the surface of adhesive A remote from the polyimide film.

Two forms of construction in accordance with the invention will be described by way of example only with reference to the accompanying drawings, in which:

Fig. 1 is a cross sectional view of a flexible printed circuit board construction according to this invention.

Fig. 2 is a cross sectional view of a coverlay film according to this invention.

In the drawings, 1 represents a polyimide film, 2 represents thermosetting adhesive A, 3 represents thermosetting adhesive B, 4 represents metal foil, and 5 represents the release paper.

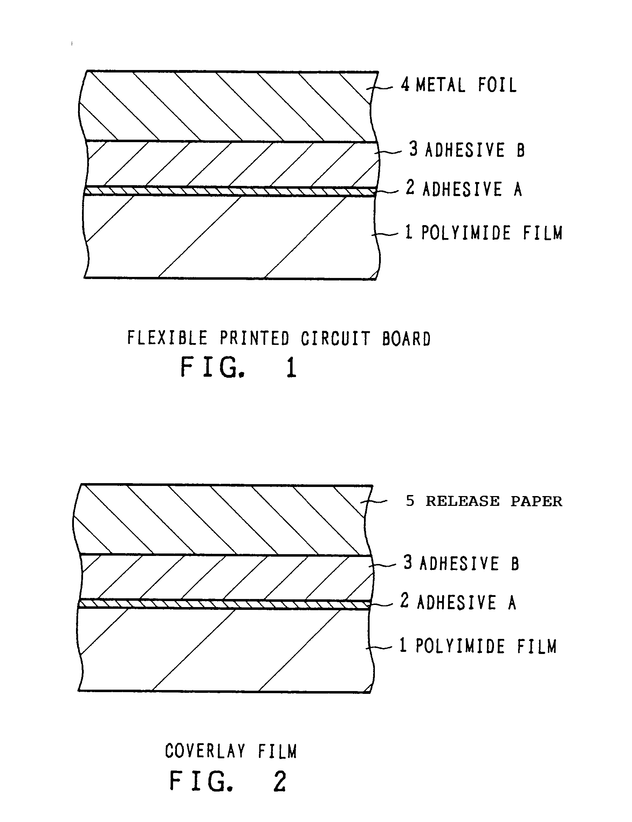

As the structure is schematically shown in Fig. 1, which illustrates by way of Example only a first preferred embodiment of a structure according to the invention, polyimide film 1 is used as electrical insulator film. The process advantageously comprises the steps of applying and drying immediately upon the film a thermosetting adhesive A 2 which contains epoxy resin, polyamide resin, and amino compound to a thickness of 5 µm or less when dried, applying and drying another thermosetting adhesive B 3 mainly containing epoxy resin, a carboxyl group-containing acrylonitrile butadiene copolymer and if desired aluminium hydroxide, attaching a metal foil 4 thereon, applying heat and pressure, and post-curing.

Accordingly, in a first preferred embodiment, the present invention provides a flexible printed circuit board comprising a metal foil attached to a polyimide film by a dual layer adhesive comprising a first thermosetting adhesive A of a thickness of at most 5 µm directly on the polyimide film and another thermosetting adhesive B on the surface of adhesive A remote from the film.

In the structure which forms a second preferred embodiment of the invention, which is schematically shown in Fig. 2, the coverlay film is manufactured using, instead of the metal foil 4 of Fig. 1, a release paper 5.

Accordingly, in a second preferred embodiment, the invention provides a coverlay film comprising a release paper on a polyimide film having a dual layer adhesive as defined above.

The flexible printed circuit board and coverlay film thus manufactured are excellent in bonding strength, thermal resistance, weatherability, electrical insulation properties and flexibility to an extent satisfying all the physical properties required of a printed circuit material. Moreover, they are less susceptible to thermal deterioration, and have improved moisture resistance and weatherability.

Although Fig. 1 shows an embodiment in which a polyimide film is provided with a metal foil only on one side thereof, this invention is applicable to boards having metal foils or release paper on both surfaces.

The flexible printed circuit board and coverlay film according to this invention are both characterized by the dual layer structure of adhesives which comprises a thermosetting adhesive A formed immediately upon the polyimide film in the thickness of 5 µm or less and another thermosetting adhesive B formed further thereon.

The manufacturing method for flexible printed circuit board or for coverlay film according to this invention is characterized by the steps of applying and drying, on a polyimide film, a thermosetting adhesive A in the thickness of 5 µm or less when dried, then applying and drying a thermosetting adhesive B further thereon, and attaching a metal foil, or applying a release paper, thereto.

The thermosetting adhesive A is prepared preferably by mixing 100 parts of epoxy resins, 5-50 parts of polyamide resin, 0-15 parts of amino compound and 0.1-0.5 part of tertiary amine. The thermosetting adhesive B is prepared preferably by mixing 100 parts of epoxy resin, 40-160 parts of carboxyl group-containing acrylonitrile butadiene copolymer, 0-60 parts of aluminium hydroxide, 0-2.0 parts of zinc oxide, 4-15 parts of epoxy resin curing agent, and 0.2-1.0 part of curing catalyst.

As the epoxy resin used in the thermosetting adhesive A, an epoxy resin having 2 or more epoxy groups in one molecule is desirable. The resin may, for example, be bisphenol A epoxy resin, bisphenol F epoxy resin, novolak epoxy resin, polyglycidyl ether of carboxylic acid, urethane modified epoxy resin, or brominated epoxy resin, or a mixture of two or more such resins.

Commercially available epoxy resins which may with advantage be used for the purpose are Epikote* series (Shell Chemicals), Araldite * series (CIBA Geigy), DER* series (Dow Chemical), or Epiclon* series (Dainippon Ink Chemical Industries).
* Trade Marks

The polyamide resin to be used in the thermosetting adhesive A is preferably an aliphatic amide/amine compound having an amide group which is crosslinked with the epoxy group, and acts as a curing agent for liquid or solid epoxy resins.

Commercially available polyamide resins which are soluble in solvents may be used. They are Amilan* CM 4000 and CM 8000 (by Toray), Polymide* series (Sanyo Kasei Kogyo), Versamid* series (Daiichi General Sha), and Genamid* series (Henkel Hakusui Sha).
* Trade Mark

As another curing agent for the thermosetting adhesive A, one or more of dicyandiamide, aliphatic amine compounds having tertiary amine as a curing catalyst, and an aromatic amine, for example, imidazole may be added.

Those materials are advantageously dissolved in an organic solvent, which may be a ketone, alcohol, or aromatic organic solvent adjusted to have solid content of 10-50%.

The thermosetting adhesive A is advantageously an epoxy-amino compound formed by epoxy resin, two types of amino compounds, a polyamide resin and dicyandiamide, which constitutes a remarkable characteristic of this invention.

It is necessary to limit the thickness of the thermosetting adhesive A to 5 µm or less. Unless limited to a value within this range, the effect as a buffer agent would become insufficient and the adhesive cannot achieve the intended object.

As the thermosetting adhesive B, all the epoxy resins which may be used as the epoxy resin of adhesive A may be used.

The polymerization degree of the acrylonitrile butadiene copolymer containing carboxyl groups is normally not critical, but copolymers of medium to high molecular weight are preferable. Such copolymers are commercially available as Nippol* 1072 and 1072J (by Nippon Zeon), Hycar * CTBN 1300XB, CTBN 1300X15 and CTBX 1300XB (B F Goodrich Chemicals).
* Trade Marks

The curing agent for the epoxy resin to be used for thermosetting adhesive may be an aliphatic or aromatic amine, but it is preferably an aromatic amine such, for example, as diaminodiphenyl sulfone, diaminodiphenylmethane, or 2-dimethylaminomethyl phenol.

Salts with a Lewis acid are preferable as the curing catalyst, which may be a triethanolamine/trifluoroboron complex, a hexylamine/trifluoroboron complex, or a monoethylamine/trifluoroboron complex.

As is apparent from the examples, addition of fine particles of aluminium hydroxide to adhesive B is found to be quite effective in improving bonding strength between metal, e.g., copper, foil and the film after boiling, or the bonding strength after contact with moisture.

A fire retardant additive may be included in the composition, for example, a mixture of bromine compounds and antimony compounds may be used. The bromine compound may, for example, be pentabromobenzene, hexabromobenzene, tetrabromobenzene, hexabromodiphenyl ether, decabromodiphenyl ether, tetrabromo bisphenol A or dibromo glycidyl ether. The antimony compound may be antimony trioxide, antimony pentoxide, or sodium antimonate.

The polyimide film to be used for this invention may, for example, be Kapton* (DuPont), Upilex* (Ube Industries) or Apikal* (Kanegafuchi Chemicals). Those films of which the surface is treated for sand-matte finish or with plasma for improved bonding strength may be used. The thickness may be, for example, 18 µm - 125 µm.
* Trade Marks

This flexible printed circuit board according to the invention may be manufactured by the steps of applying, drying and curing a thermosetting adhesive A on a polyimide film to a thickness of 5 µm or less, applying and drying thereon a thermosetting adhesive B, pasting with, for instance, a copper foil at the B stage, either by contact-bonding with press or continuously with nip rollers, and curing with heat. The invention coverlay film which is used for circuit protection may be manufactured by pasting a release paper on the adhesive at the B stage before pasting on the copper foil.

The flexible printed circuit board and coverlay film according to this invention are structured in dual layers comprising a thermosetting adhesive A which is formed in the thickness of ca. 5 µm or less on a polyimide film and a thermosetting adhesive B formed thereupon. The adhesive A acts as a buffer layer between the polyimide film and the thermosetting adhesive B, forming epoxy-amino compound with for instance, epoxy resin, two types of amino compound, namely a polyamide resin and dicyandiamide, to enhance the bonding strength with the polyimide film and to improve properties, particularly of moisture resistance and weatherability.

The thermosetting adhesive B may be prepared primarily using the conventional materials which meet the usual requirements of flexible printed circuit boards and coverlay film.

By the method mentioned above, it becomes possible to produce a flexible printed circuit board and coverlay film which are excellent in bonding strength, thermal resistance, chemical resistance, electrical insulation properties, flexibility and fire retardant property as well as moisture resistance and weatherability.

The following Examples illustrate the invention: (Examples 1 to 5, and Comparative Examples 1 to 3, relate to a flexible printed circuit board.)

A thermosetting adhesive A was mixed and dissolved in methyl ethyl ketone/xylene = 1 : 1 at a solids content of 15%, and applied on a 25 µm thick polyimide film to form a layer of thickness 3 µm. The layer was dried at 150°C for 5 minutes. A thermosetting adhesive B was mixed and dissolved in methyl ethyl ketone/xylene = 1 : 1 at a solids content of 30%, applied on the said layer at a thickness of 25 µm, dried at 120°C for 5 minutes, bonded with a 35 µm thick copper foil with rollers by heating, and subjected to post-curing to produce a flexible printed circuit board with copper foil.

The bonding conditions were 130°C, 5 kg/cm, 0.5 sec., then the post-curing was conducted stepwise at 80°C for 8 hours at 120°C for 8 hours followed by 150°C for 8 hours.

The compounding ratios of the thermosetting adhesives were varied in 5 stages as shown in the Table for Examples 1 through 5. The table shows the characteristics obtained.

The three types of comparative mixtures shown in the Table were mixed and dissolved in methyl ethyl ketone/xylene 1 : 1 at a concentration of 30%, and were processed in a manner similar to Examples 1 to 5 to manufacture flexible printed circuit boards with copper foil. The table shows the characteristics obtained.

As is apparent from the table, Examples 1 to 5 had equal or higher bonding strength under normal conditions, soldering resistance, electrical insulation properties and superior thermal resistance, moisture resistance, as well as weatherability of the bonding and fire retardant characteristics than Comparative Examples 1 to 3.

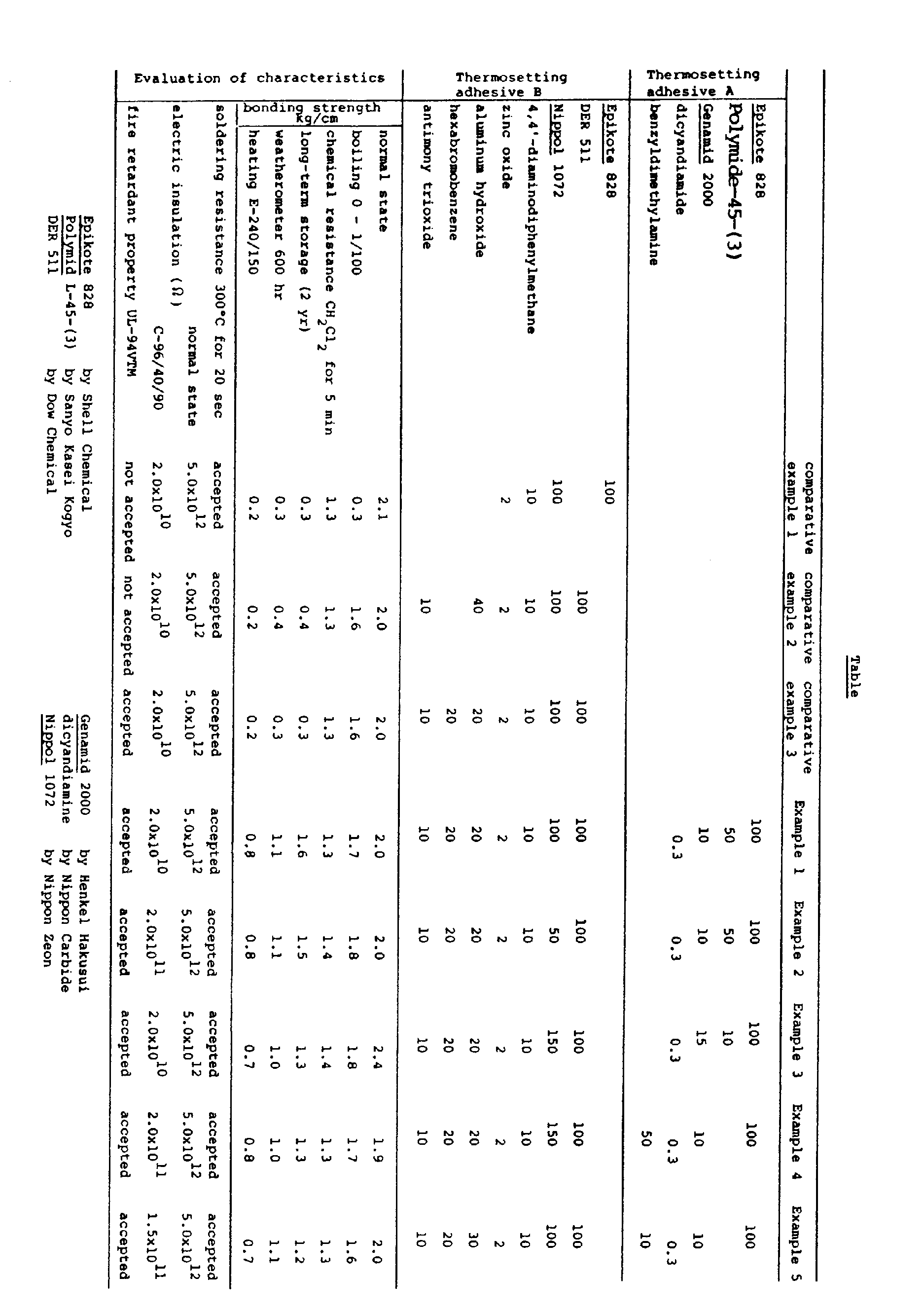

### Example 6 (Coverlay film)

A thermosetting adhesive A was mixed and dissolved in methyl ethyl ketone/xylene = 1 : 1 at a solids content of 15%, and applied on a 25 µm thick polyimide film to form a layer of 3 µm thick. The layer was dried at 150°C for 5 minutes. A thermosetting adhesive B was mixed and dissolved in methyl ethyl ketone/xylene = 1 : 1 at a solids content of 30%, applied on the layer at a thickness of 30 µm, dried at 120°C for 5 minutes, and press-bonded with a release paper with rollers to produce a circuit protection overlay. The compounding ratios of the thermosetting adhesives A and B were identical to those of Example 1 in the table.

Then the release paper was peeled off, and a copper foil of thickness 35 µm was press-bonded using rollers. The layer was post cured to produce a flexible printed circuit board with copper foil. The bonding was conducted at 130°C, 5 kg/cm², for 0.5 sec while the post-curing was conducted stepwise at 80°C for 8 hours + 120°C for 8 hours + 150°C for 8 hours.

The flexible printed circuit board thus obtained showed characteristics similar to those obtained for Example 1 shown in Table. The coverlay film of Example 6 was proven to sufficiently satisfy the requirements.

As described in the foregoing statement, this invention used a polyimide film as an electrical insulation film, and the invention method comprises the steps of forming a dual-layer structure of a thermosetting adhesive A applied immediately on the polyimide film at a maximum thickness of 5 µm and a thermosetting adhesive B applied further thereon. The flexible printed circuit board and coverlay film for circuit protection thus manufactured have remarkable effects as they are excellent in thermal resistance, boiling resistance and weatherability, show extremely low decreases in bonding strength after heating and bonding strength after treatment in a weatherometer as well as after boiling, and show excellent fire retardant property.

## Claims

1. A polyimide film having on at least one primary surface a dual layer adhesive comprising a first thermosetting adhesive A in the form of a layer of thickness at most 5 µm and a second thermosetting adhesive B, different from adhesive A, on the surface of adhesive A remote from the polyimide film.

2. A film as claimed in claim 1, wherein adhesive A is derivable from an epoxy resin, a polyamide, a tertiary amine and, optionally, an amino compound, and adhesive B is derivable from an epoxy resin, a carboxyl group-containing acrylonitrile-butadiene copolymer, and a curing agent for the epoxy resin.

3. A film as claimed in claim 1, wherein the components of the thermosetting adhesive A are per 100 parts epoxy resin: polyamide resin, advantageously 5-50 parts, amino compound, advantageously 0-15 parts, and optionally a tertiary amine, advantageously 0.1-0.5 parts, while the components of the thermosetting adhesive B are per 100 parts epoxy resin: acrylonitrile-butadiene copolymer containing carboxyl groups, advantageously 40-160 parts, aluminium hydroxide, advantageously 0-60 parts, zinc oxide, advantageously 0-2.0 parts, epoxy-resin curing agent advantageously 4-15 parts, and optionally curing catalyst advantageously 0.2-1.0 part.

4. A film as claimed in claim 3, wherein the amino compound of said thermosetting adhesive A is dicyandiamide, the tertiary amine thereof is benzyldimethylamine, the epoxy resin curing agent in said thermosetting adhesives A and B is an aromatic amine, and the curing catalyst is a trifluoroboron complex which is a tertiary amine.

5. A film as claimed in any one of claims 1 to 4, wherein adhesive B contains finely divided aluminium hydroxide.

6. A film as claimed in any one of claims 1 to 5, which has the specified dual layer adhesive on both faces.

7. A flexible printed circuit board comprising a polyimide film as defined in any one of claims 1 to 6 having a metal foil attached to a primary surface having the dual layer adhesive thereon.

8. A coverlay film comprising a polyimide film as defined in any one of claims 1 to 6 having a release paper on a primary surface having the dual layer adhesive thereon.

9. A method for manufacturing a flexible printed circuit board by attaching a metal foil, or for manufacturing a coverlay film by applying a release paper, on a polyimide film using adhesives, characterized in that the method includes the steps of applying and drying on said polyimide film a thermosetting adhesive A to a thickness of at most 5 µm when dried, applying and drying further thereon a different thermosetting resin B, and subsequently attaching the metal foil, or applying the release paper, thereto.

10. A method as claimed in claim 9, wherein adhesive A comprises epoxy resin 100 parts, polyimide resin 5-50 parts, amino compound 0-15 parts, and tertiary amine 0.1-0.5 part and adhesive B comprises epoxy resin 100 parts, acrylonitrile butadiene copolymer containing carboxyl groups 40-160 parts, aluminium hydroxide 0-60 parts, zinc oxide 0-20 parts, epoxy resin curing agent 4-15 parts, and curing catalyst 0.2-1.0 part.

## Patentansprüche

1. Polyimidfolie, die auf mindestens einer Hauptoberfläche ein Zweischichtenklebemittel aufweist, das ein erstes durch Wärme härtbares Klebemittel A in Form einer Schicht von höchstens 5 µm Dicke und ein zweites durch Wärme härtbares Klebemittel B, das von dem Klebemittel A verschieden ist, auf der Oberfläche von Klebemittel A, die von der Polyimidfolie entfernt ist, umfaßt.

2. Folie nach Anspruch 1, wobei Klebemittel A von einem Epoxyharz, einem Polyamid, einem tertiären Amin und gegebenenfalls einer Aminoverbindung ableitbar ist und Klebemittel B von einem Epoxyharz, einem Carboxylgruppen enthaltenden Acrylnitril/Butadien-Copolymer und einem Härtungsmittel für das Epoxyharz ableitbar ist.

3. Folie nach Anspruch 1, wobei die Komponenten des durch Wärme härtbaren Klebemittels A pro 100 Teile Epoxyharz sind: Polyamidharz, vorteilhafterweise 5 bis 50 Teile, Aminoverbindung, vorteilhafterweise 0 bis 15 Teile und gegebenenfalls ein tertiäres Amin, vorteilhafterweise 0,1 bis 0,5 Teile, während die Komponenten des durch Wärme härtbaren Klebemittels B pro 100 Teile Epoxyharz sind: Carboxylgruppen enthaltendes Acrylnitril/Butadien-Copolymer, vorteilhafterweise 40 bis 160 Teile, Aluminiumhydroxid, vorteilhafterweise 0 bis 60 Teile, Zinkoxid, vorteilhafterweise 0 bis 2,0 Teile, Epoxyharz-Härtungsmittel, vorteilhafterweise 4 bis 15 Teile, und gegebenenfalls Härtungskatalysator, vorteilhafterweise 0,2 bis 1,0 Teile.

4. Folie nach Anspruch 3, wobei die Aminoverbindung des durch Wärme härtbaren Klebemittels A Dicyandiamid ist, dessen tertiäres Amin Benzyldimethylamin ist, das Epoxyharz-Härtungsmittel in den durch Wärme härtbaren Klebemitteln A und B ein aromatisches Amin ist und der Härtungskatalysator ein Trifluorborkomplex ist, der ein tertiäres Amin ist.

5. Folie nach einem der Ansprüche 1 bis 4, wobei Klebemittel B fein zerteiltes Aluminiumhydroxid enthält.

6. Folie nach einem der Ansprüche 1 bis 5, die das spezifizierte Zweischichtenklebemittel auf beiden Seiten trägt.

7. Biegsame Leiterplatte, die eine Polyimidfolie wie in einem der Ansprüche 1 bis 6 definiert mit einer Metallfolie angeheftet auf eine Hauptoberfläche umfaßt, auf der sich das Zweischichtenklebemittel befindet.

8. Deckschichtfolie, die eine Polyimidfolie wie in einem der Ansprüche 1 bis 6 definiert umfaßt und ein Trennpapier auf einer Hauptoberfläche, auf der sich das Zweischichtenklebemittel befindet, aufweist.

9. Verfahren zur Herstellung einer biegsamen Leiterplatte durch Anheften einer Metallfolie oder zur Herstellung einer Deckschichtfolie durch Aufbringen eines Trennpapiers auf eine Polyimidfolie unter Verwendung von Klebemitteln, dadurch gekennzeichnet, daß bei dem Verfahren ein durch Wärme härtbares Klebemittel A bis zu einer Dicke von höchstens 5 µm im trockenen Zustand auf die Polyimidfolie appliziert und getrocknet wird, weiterhin auf die Folie ein anderes durch Wärme härtbares Harz B appliziert und getrocknet wird und nachfolgend die Metallfolie daran angeheftet oder das Trennpapier darauf aufgebracht wird.

10. Verfahren nach Anspruch 9, wobei Klebemittel A 100 Teile Epoxyharz, 5 bis 50 Teile Polyimidharz, 0 bis 15 Teile Aminoverbindung und 0,1 bis 0,5 Teile tertiäres Amin umfaßt und Klebemittel B 100 Teile Epoxyharz, 40 bis 160 Teile Carboxylgruppen enthaltendes Acrylnitril/Butadien-Copolymer, 0 bis 60 Teile Aluminiumhydroxid, 0 bis 20 Teile Zinkoxid, 4 bis 15 Teile Epoxyharz-Härtungsmittel und 0,2 bis 1,0 Teile Härtungskatalysator umfaßt.

## Revendications

1. Une pellicule en polyimide portant, sur au moins une surface primaire, un adhésif en double couche comprenant un premier adhésif thermodurcissant A sous forme d'une couche d'une épaisseur d'au plus 5 µm et un deuxième adhésif thermodurcissant B, différent de l'adhésif A, sur la surface de l'adhésif A distante de la pellicule de polyimide.

2. Une pellicule selon la revendication 1, dans laquelle l'adhésif A peut être dérivé d'une résine époxy, d'un polyamide, d'une amine tertiaire et, éventuellement, d'un composé amino, et l'adhésif B peut être dérivé d'une résine époxy, d'un copolymère acrylonitrile-butadiène comprenant un groupe carboxyle, et d'un agent de cuisson de la résine époxy.

3. Une pellicule selon la revendication 1, dans laquelle les composants de l'adhésif thermodurcissant A sont, pour 100 parties de résine époxy : résine de polyamide, de façon avantageuse 5 à 50 parties, composé amino, de façon avantageuse 0 à 15 parties, et éventuellement une amine tertiaire, de façon avantageuse 0,1 à 0,5 partie, tandis que les composants de l'adhésif thermodurcissant B sont, pour 100 parties de résine d'époxy : copolymère d'acrylonitrile-butadiène contenant des groupes carboxyles, de façon avantageuse 40 à 160 parties, hydroxyde d'aluminium, de façon avantageuse 0 à 60 parties, oxyde de zinc, de façon avantageuse 0 à 2,0 parties, agent de cuisson de résine époxy, de façon avantageuse 4 à 15 parties, et éventuellement catalyseur de cuisson, de façon avantageuse 0,2 à 1,0 partie.

4. Une pellicule selon la revendication 3, dans laquelle le composé amino dudit adhésif thermodurcissant A est le dicyandiamide, l'amine tertiaire de cet adhésif est la benzyl-diméthylamine, l'agent de cuisson de la résine époxy dans lesdits adhésifs thermodurcissants A et B est une amine aromatique, et le catalyseur de cuisson est un complexe de trifluorobore qui est une amine tertiaire.

5. Une pellicule selon l'une quelconque des revendications 1 à 4, dans laquelle l'adhésif B contient de l'hydroxyde d'aluminium finement divisé.

6. Une pellicule selon l'une quelconque des revendications 1 à 5, qui porte sur ses deux faces l'adhésif en double couche spécifié.

7. Une carte flexible de circuit imprimé comportant une pellicule de polyimide telle que définie dans l'une quelconque des revendications 1 à 6, portant une feuille métallique attachée à une surface primaire pourvue de l'adhésif en double couche.

8. Une pellicule de recouvrement comprenant une pellicule de polyimide telle que définie dans l'une quelconque des revendications 1 à 6, portant un papier détachable sur une surface primaire pourvue de l'adhésif en double couche.

9. Un procédé de fabrication d'une carte flexible de circuit imprimé en attachant une feuille métallique, ou de fabrication d'une pellicule de revêtement en appliquant un papier détachable, sur une pellicule de polyimide en utilisant des adhésifs, caractérisé en ce que le procédé comprend les étapes consistant à appliquer et sécher sur ladite pellicule en polyimide un adhésif thermodurcissant A d'une épaisseur d'au plus 5 µm lorsqu'il est séché, appliquer et sécher ensuite sur celui-ci une résine thermodurcissante différente B et, ensuite, y attacher la feuille métallique ou y appliquer le papier détachable.

10. Un procédé selon la revendication 9, dans lequel l'adhésif A comprend 100 parties de résine époxy, 5 à 50 parties de résine polyimide, 0 à 15 parties de composé amino, et 0,1 à 0,5 partie d'amine tertiaire et l'adhésif B comprend 100 parties de résine époxy, 40 à 160 parties de copolymère d'acrylonitrile-butadiène contenant des groupes carboxyles, 0 à 60 parties d'hydroxyde d'aluminium, 0 à 20 parties d'oxyde de zinc, 4 à 15 parties d'agent de cuisson de résine époxy, et 0,2 à 1,0 partie de catalyseur de cuisson.
